# EUROPEAN PATENT APPLICATION

(11) **EP 3 333 467 A1**
(43) Date of publication of application: **13.06.2018**
(21) Application number: 16202613.2
(22) Date of filing: 07.12.2016
(51) Int. Cl.: F16K 37/00

(54) **SUBSEA VALVE POSITION INDICATOR**

(71) Applicant: Siemens Aktiengesellschaft, 80333 München (DE)
(72) Inventor: Eastoe, Andrew Robert, 5427 Urangsvaeg (NO); Folgeroe-Holm, Jan Inge, 5428 Foldroyhamn (NO); Haugland, Bjoern-Aksel, 5428 Foldroeyhamn (NO)

(57) **Abstract**

A valve position indicator (1, 1a) for reading the position of a valve shutter of a valve (2) associated to the valve position indicator (1, 1a), includes:
- a body (10)
- at least two linear sensors (11, 12),
- a coupling device for coupling the valve position indicator (1) to the valve (2) in such a way that the at least two linear sensors (10, 11) are adjacent to a travelling path (X) of a magnet (20) attached to the valve shutter.

## Description

### Field of invention

The present invention relates to a valve position indicator. The valve position indicator of the present invention is particularly adaptable to a valve position indicator for a subsea valve. Particularly, but not exclusively, the present invention relates to a valve position indicator for a subsea linear valve or to valve having a stem, whose movement can be associated to a linear movement of a magnetic device.

### Art Background

In many technical fields, for example in the subsea field, valves and actuators are utilized in operative conditions where the valve is physically located remote from the control and monitoring facility. It is nevertheless necessary to know when the valve shutter is in the open or closed or intermediate position, to determine their operative conditions and to provide proper control. For this purpose, electrical signals have been used to transfer information about the valve closure degree to a remote control facility.

In known systems inconveniences may occur when the electrical signal fails or in the event that erroneous electrical signals are generated.

When the electrical signal fails, as a result of a damage to the position sensor in the valve position indicator, no control of the valve is possible before the damage is detected and repaired. In the event an erroneous signal is sent to the control and monitoring facility, falsely indicating the position of a remote valve, severe damage may be caused.

### Summary of the Invention

It may be an objective of the present invention to provide a valve position indicator, which is reliable, secure and cost-effective.

These objectives are solved by a valve position indicator according to the independent claim. The dependent claims describe advantageous developments and modifications of the invention.

According to the present invention, a valve position indicator for reading the position of a valve shutter of a valve associated to the valve position indicator includes:
- a body,
- at least two linear sensors,
- a coupling device for coupling the valve position indicator to the valve in such a way that the at least two linear sensors are adjacent to a travelling path of a magnet connected to the valve shutter. According to a possible embodiment of the present invention, the linear sensors are a series of resistors connected to parallel coupled reed switches. In particular, the linear sensors may be parallel to each other. Also the travelling path may parallel to the at least two reed switches.

Advantageously, the redundancy provided by the at least two linear sensors achieve redundancy and add security with respect to failures. Cost benefits derive from the fact that a plurality of sensors is integrated in a single indicator. This allows valve position indicator to be efficiently coupled to a subsea valve, in particular a subsea valve including a linear shutter or a subsea valve, whose shutter movement can actuate the movement of the magnet along the travelling path.

According to a first possible embodiment, the body includes a cavity, inside which the travelling path is defined. According to a second possible embodiment, the body includes an external surface, adjacent to which the travelling path is defined. In particular, in operation, the external surface may interposed between the travelling path and the at least two linear sensors.

According to embodiments of the present invention, the travelling path is equidistant from the at least two linear sensors. This assures that the measurements performed by the two sensors are identical.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment, but to which the invention is not limited.
Fig. 1 shows an axonometric view of a first embodiment of a valve position indicator according to the present invention,
Fig. 2 shows a lateral view of the valve position indicator of Fig. 1,
Fig. 3 shows a frontal view of the valve position indicator of Fig. 1,
Fig. 4 shows a sectional view of the valve position indicator of Fig. 1, according to the sectional line IV-IV of Fig. 3,
Fig. 5 shows a sectional view of the valve position indicator of Fig. 1, according to the sectional line V-V of Fig. 4,
Fig. 6 shows an axonometric view of a second embodiment of a valve position indicator according to the present invention,
Fig. 7 shows a frontal view of the valve position indicator of Fig. 6.

### Detailed Description

The illustrations in the drawings are schematic. It is noted that in different figures, similar or identical elements are provided with the same reference signs, also when they refer to different embodiments of the invention.

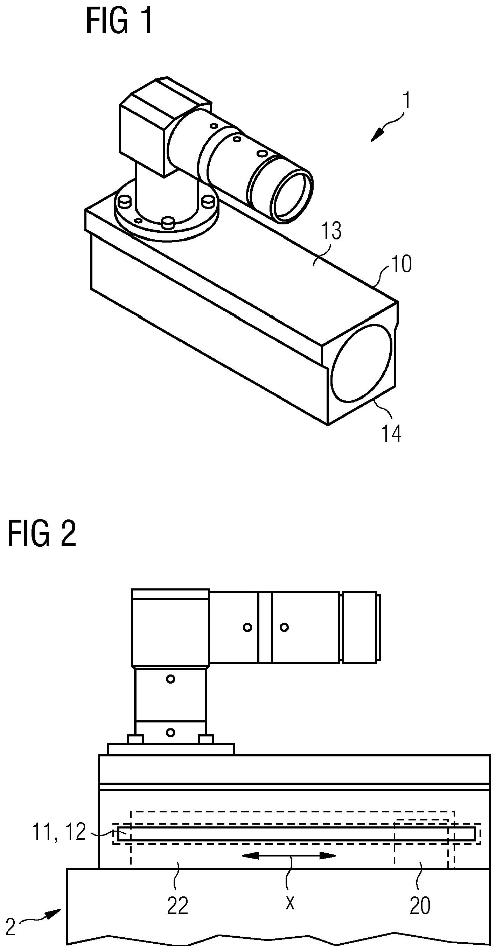

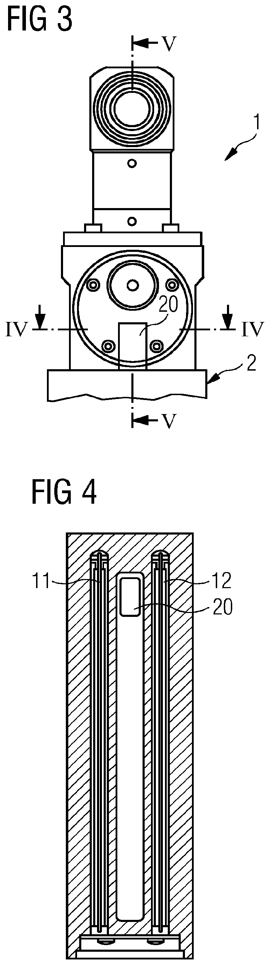

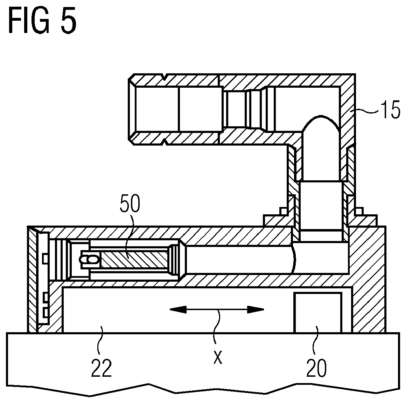

**Fig. 1** to **5** shows a first embodiment of a valve position indicator 1 for reading the position of a valve shutter (not shown) of a subsea valve 2 (only schematically represented in the attached figures) associated to the valve position indicator 1.

The subsea valve 2 includes a stem (not shown) connected to a shutter of the valve. The shutter may linear or rotational. The stem is further connected to a magnet 20 in such a way that the movement of the stem between an opened and a closed position of the subsea valve determines the movement of the magnet 20 along a linear travelling path, symbolically represented in the attached figure by the double arrow X.

The valve position indicator 1 includes a body 10 having the shape of a parallelepiped with an upper face 13 and an opposite lower face 14. On the upper face 13 a connector 15 is provided for connecting the valve position indicator 1 to a supporting structure (not shown). The connector 15 is hollow to allow the passage of the electrical connection (not shown) powering the valve position indicator 1.

In the body 10 a cavity 22 opened at the lower face 14. The cavity 22 has a parallelepiped shape and is dimensioned in such a way to provide, in operation, i.e. when the valve position indicator 1 is coupled with the subsea valve 2, housing for the magnet 20.

The travelling path X is defined inside the cavity 22. This means that, in operation, the magnet 20 travels along the travelling path X while moving, at least in part, within the cavity 20.

The valve position indicator 1 and the subsea valve 2 comprise respective coupling device (not shown in the attached figures) to be coupled together in such a way that the above conditions is achieved.

The body 10 further includes two linear position sensors 11, 12, for measuring the position of the magnet 20 along the travelling path X. For the linear position sensors 11, 12 two respective reed switches are used, place in respective cavities adjacent to the cavity 22. The linear position sensors 11, 12 are equidistant from the lower face 14 and equidistant from the travelling path X. The two linear position sensors 11, 12 and the travelling path X are parallel to each other. According to other possible embodiments (not shown) of the invention, the valve position indicator 1 includes more than two linear sensors, all capable of measuring the position of the magnet 20 along the travelling path X.

The body 10, between the linear position sensors 11, 12 and the upper surface 13, comprises a plurality of electronic devices 50 for receiving the information about the position of the magnet 20 from the linear position sensors 11, 12 and transmitting them outside the valve position indicator 1 through the hollow connector 15. The electronics 50 of the valve position indicator 1 are conventional and known in the art and for this reason not described in further details.

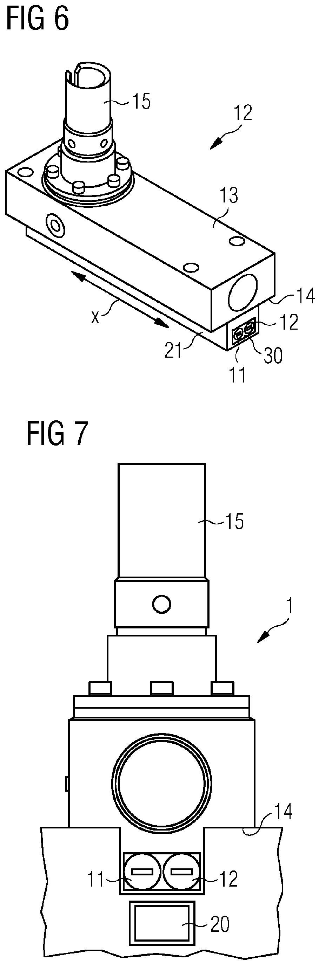

**Fig. 6** and **7** shows a second embodiment of a valve position indicator 1a for reading the position of a valve shutter (not shown) of a subsea valve 2 (only schematically represented in the attached figures) associated to the valve position indicator 1. The valve position indicator 1a is basically identical to valve position indicator 1 of the first embodiment, with the main difference that the body 10 do not include the cavity 22 for housing the magnet 20. Instead the valve position indicator 1a includes a protrusion 21 extending from the lower surface 14 of the body. The linear position sensors 11, 12 (reed switches) are provided in the protrusion 21, adjacent to an external surface 30 of the protrusion 21. In operation, the travelling path X of the magnet 20is adjacent to the external surface 30, on the opposite side with respect to the linear position sensors 11, 12. In other words, in operation, the external surface 3 is interposed between the travelling path X of the magnet 20 and the linear position sensors 11, 12.

Also in this second embodiment, the travelling path X of the magnet 20 is parallel and equidistant to the linear position sensors 11, 12.

In all the embodiments of the present invention, the failing or not correct working of one of the linear position sensors 11, 12 does not prevent the position of the magnet 20 to be read, thanks to the redundancy provided by another of the linear position sensors 11, 12.

## Claims

1. Valve position indicator (1, 1a) for reading the position of a valve shutter of a valve (2) associated to the valve position indicator (1, 1a), the valve position indicator (1) including:
- a body (10)
- at least two linear sensors (11, 12),
- a coupling device for coupling the valve position indicator (1, 1a) to the valve (2) in such a way that the at least two linear sensors (10, 11) are adjacent to a travelling path (X) of a magnet (20) connected to the valve shutter.

2. The valve position indicator (1, 1a) according to claim 1, wherein the two linear sensors (11, 12) are a series of resistors connected to parallel coupled reed switches.

3. The valve position indicator (1) according to claim 1 or 2, wherein the body (10) includes a cavity (22), inside which the travelling path (X) is defined.

4. The valve position indicator (1a) according to claim 1 or 2, wherein the body (10) includes an external surface (30), adjacent to which the travelling path (X) is defined.

5. The valve position indicator (1, 1a) according to claim 3 or 4, wherein the travelling path (X) is equidistant from the at least two linear sensors (11, 12).

6. The valve position indicator (1, 1a) according to claim 4, wherein in operation the external surface (30) is interposed between the travelling path (X) and the at least two linear sensors (11, 12).

7. The valve position indicator (1, 1a) according to any of the preceding claims, wherein the at least two linear sensors (10, 11) are parallel.

8. The valve position indicator (1, 1a) according to claim 7, wherein the travelling path (X) is parallel to the at least two linear sensors (10, 11).

9. Valve (2) for subsea application including a valve position indicator (1, 1a) according to any of the preceding claim.

10. The valve (2) according to claim 9, wherein the valve include a linear shutter.
